Europäisches Patentamt

European Patent Office

Office européen des brevets

(19)

(11) **EP 1 084 416 B1**

(12) **FASCICULE DE BREVET EUROPEEN**

(45) Date de publication et mention
de la délivrance du brevet:
**12.11.2003 Bulletin 2003/46**

(21) Numéro de dépôt: **99923668.0**

(22) Date de dépôt: **04.06.1999**

(51) Int Cl.⁷: **G01R 13/34**

(86) Numéro de dépôt international:
**PCT/FR99/01319**

(87) Numéro de publication internationale:
**WO 99/064873 (16.12.1999 Gazette 1999/50)**

(54) **ECHANTILLONNEUR ELECTRIQUE**

ELEKTRISCHER SAMPLER

ELECTRIC SAMPLER

(84) Etats contractants désignés:
**DE GB IT**

(30) Priorité: **05.06.1998 FR 9807087**

(43) Date de publication de la demande:
**21.03.2001 Bulletin 2001/12**

(73) Titulaire: **COMMISSARIAT A L'ENERGIE
ATOMIQUE
75752 Paris Cédex 15 (FR)**

(72) Inventeurs:
• **GHIS, Anne
F-38400 St Martin d'Hères (FR)**

• **AJRAM, Sami
F-59650 Villeneuve D'Ascq (FR)**

(74) Mandataire: **Audier, Philippe André et al
Brevalex,
3, rue du Docteur Lancereaux
75008 Paris (FR)**

(56) Documents cités:
**EP-A- 0 086 305**      **WO-A-83/02829**
**WO-A-93/13427**      **WO-A-94/06121**
**DE-A- 2 047 738**      **FR-A- 2 764 070**
**US-A- 3 925 727**      **US-A- 5 457 637**

**Description**

Domaine technique

L'invention concerne le domaine des échantillonneurs électriques, en particulier pour des impulsions présentant des durées courtes ou très courtes.

La métrologie d'impulsions permet de décrire l'évolution temporelle d'un signal, ou d'une impulsion électrique, en particulier de sa tension ou de son énergie, lorsque ce signal, ou cette impulsion, est, par exemple, unique (non répétitive), et très brève (c'est-à-dire présente une durée de l'ordre de quelques dizaines, ou quelques centaines de picosecondes).

De telles impulsions à mesurer sont généralement issues de détecteurs de rayonnement très rapides, qui convertissent en impulsions électriques l'énergie d'une impulsion de rayonnement qu'ils reçoivent, par exemple une impulsion de rayonnement X ou gamma, ou visible, ou infrarouge. De tels rayonnements peuvent être émis par des sources de rayonnement ultrarapides, telles que des lasers ou des sources de rayonnement synchrotron, ou peuvent être le résultat d'une interaction laser-matière provoquée par un laser ultrarapide (c'est-à-dire dont la durée de l'impulsion est du domaine de la picoseconde ou de la femtoseconde).

L'invention peut s'appliquer à toute mesure de signal électrique très bref, notamment non répétitif, en particulier dans la physique d'événements, ou dans la mesure d'événements, générés par des phénomènes picosecondes.

Etat de la technique

Il existe actuellement sur le marché des oscilloscopes à échantillonnage pour mesure de signaux dont le spectre s'étend jusqu'à 50GHz ou 70GHz. Ces appareils permettent de mesurer des impulsions répétitives. La fréquence d'échantillonnage est variable, de 250 KHz à 1 GHz.

Pour mesurer des impulsions uniques, des appareils commercialisés existent sur le marché : ils permettent de restituer un spectre jusqu'à 5GHz ou 7GHz.

Parmi les prototypes de laboratoire, on connaît le dispositif décrit dans le document US-5 471 162. Un tel dispositif repose sur le principe de l'échantillonnage spatial d'une impulsion. Une impulsion se propage sur une ligne de propagation. Il en résulte une équivalence spatiale de l'évolution temporelle de cette impulsion qui se propage sur la ligne avec une vitesse dépendant des caractéristiques physiques de celle-ci. A un instant t déterminé, si la ligne est de longueur suffisante, la totalité de l'impulsion est spatialement répartie le long de la ligne.

Si des échantillonneurs sont disposés le long de la ligne de propagation, leur actionnement simultané permet de réaliser un échantillonnage complet de l'impulsion, avec un pas temporel égal au pas spatial des échantillonneurs, divisé par la vitesse de propagation.

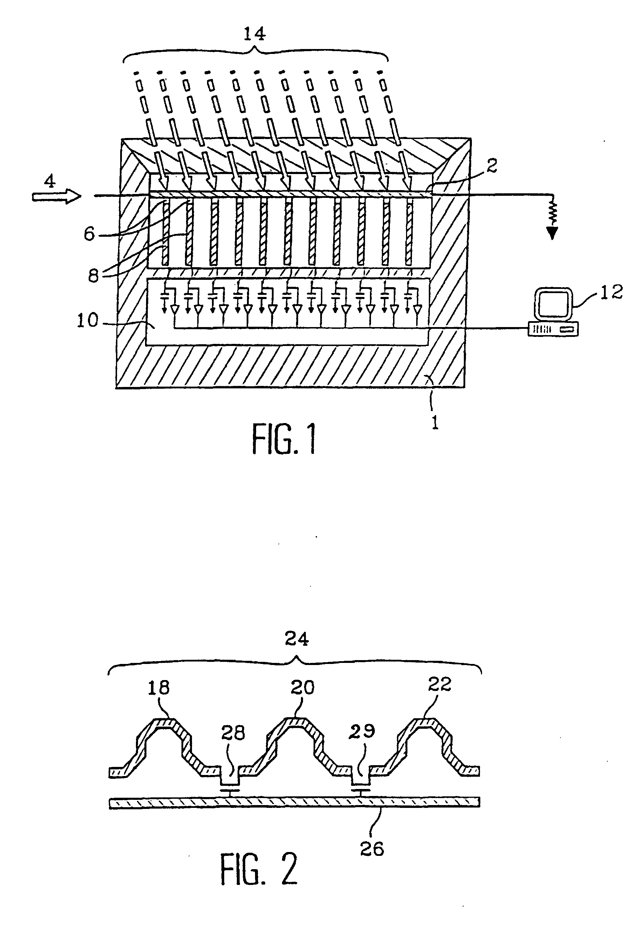

On connaît également un dispositif optoéchantillonneur qui mesure des signaux de bande passante jusqu'à 35GHz. Ce dispositif est illustré sur la figure 1. Il comporte une ligne de propagation 2 dans laquelle est introduit et le long de laquelle se propage un signal impulsionnel 4 à mesurer. Le long de la ligne de propagation sont disposées, de manière régulière, des portes d'échantillonnage 6 en un matériau photoconducteur (CdTe). Ces portes d'échantillonnage sont associées à des lignes de prélèvement 8, chacune étant elle-même suivie d'un moyen de lecture des charges. L'ensemble des moyens de lecture des charges est rassemblé dans un dispositif 10 de lecture des charges. ces moyens de lecture de charges sont reliés à un ordinateur 12 programmé pour mesurer les charges relatives à chaque canal et analyser l'impulsion 4. Chaque porte d'échantillonnage 6 est fermée grâce à une impulsion lumineuse 14 de déclenchement : il faut une impulsion lumineuse de déclenchement qui se répartit sur toutes les portes d'échantillonnage. Ce dispositif nécessite donc un flash optique picoseconde de quelques dizaines de nanojoules pour déclencher l'échantillonnage.

Ces échantillonneurs connus sont donc des photoconducteurs, dans le cas de l'optoéchantillonneur (figure 1) et des diodes dans le cas du digitaliseur compact.

Dans ces structures connues, des échantillonneurs prélèvent une partie du signal présent à leur niveau sur la ligne. Ils sont placés en parallèle sur cette ligne de propagation.

Le document FR-97 06534 décrit un échantillonneur électrique monocoup pour impulsions courtes.

Le principe de cet échantillonneur électrique, avec tronçons de ligne est illustré sur la figure 2.

Une structure, ou ligne, 24 de propagation d'impulsions électriques comporte une pluralité de tronçons 18, 20, 22 de cette structure. Les différents tronçons sont reliés deux à deux par des interrupteurs 28, 29, constitués par exemple de MESFET AsGa (ou Si, ou de transistors MOS ou de transistors bipolaires sur Si).

Des moyens de commande des interrupteurs 28, 29 comportent par exemple une seconde structure de propagation 26 d'impulsions de déclenchement, à laquelle sont connectés les interrupteurs 28.

Sur la figure 2, seuls trois tronçons de la ligne 24 ont été représentés, mais la ligne peut comporter un nombre quelconque de tronçons, séparés deux à deux et reliés deux à deux par des interrupteurs.

Un signal à échantillonner se propage le long de la structure de propagation, ou de la ligne de propagation 24.

Le long de la ligne de propagation 26 se propage un signal de synchronisation, par exemple un créneau échelon de tension. Les interrupteurs sont normalement passants, ou fermés, et l'échelon de tension ouvre ces interrupteurs. Cet échelon ou ce créneau, isole donc chaque tronçon de la ligne de propagation, qui sert alors de capacité de stockage.

La totalité des charges véhiculées par l'impulsion est alors confinée dans les différents tronçons 18, 20, 22 constituant la structure de propagation de l'impulsion.

La structure illustrée sur la figure 2 comporte donc :

- d'une part une première structure de propagation 24, où se propage la quantité de charges à mesurer, et qui est constituée de tronçons reliés deux à deux par des interrupteurs initialement fermés,
- d'autre part une seconde structure de propagation dans laquelle peut se propager un signal de synchronisation de type "échelon" ; au moment du passage de l'échelon, celui-ci modifie la commande de l'état de l'interrupteur de façon à ce qu'il s'ouvre, et isole les deux tronçons auquel il est relié, des charges étant alors piégées dans un tronçon lorsque les deux interrupteurs qui le bornent sont ouverts. Ce sont ces charges qui sont ensuite lues par un dispositif de lecture approprié.

Le dispositif est complété par des moyens pour générer un signal de synchronisation, reliés à la structure 26 de propagation d'impulsions de synchronisation. Par ailleurs, ils peuvent être reliés à un dispositif de lecture des charges dans les tronçons.

Ces échantillonneurs ont une bande passante limitée, liée à la bande passante de la ligne elle-même. De plus la sensibilité de détection (c'est-à-dire la quantité de charges prélevée dans le signal) est également limitée. En ce qui concerne l'optoéchantillonneur, l'utilisation d'un laser picoseconde de forte puissance impose des contraintes financières et expérimentales très importantes.

Enfin, tous ces dispositifs nécessitent une ligne de propagation très longue, altérant le signal de façon non uniforme.

Il est également connu du brevet US 5,457,637 un dispositif et un procédé d'analyse de signal par échantillonnage.

Exposé de l'invention

L'invention concerne un nouvel échantillonneur électrique. Elle concerne notamment un analyseur de signaux fugitifs, mettant en oeuvre un procédé d'échantillonnage spatial non simultané.

Elle concerne également un analyseur de signaux fugitifs, mettant en oeuvre une technologie nouvelle de couplage de substrats.

Un tel analyseur peut être utilisé pour le diagnostic laser. Son domaine d'application s'étend aussi à la mesure de signaux monocoups rapides de toutes origines, par une adaptation simple.

Plus précisément, l'invention a pour objet un échantillonneur électrique comprenant :

- une structure de propagation d'impulsions électriques,
- une ligne de propagation de signaux d'échantillonnage,
- N moyens d'échantillonnage distincts reliés, d'une part, à des points d'échantillonnage le long de la structure de propagation et, d'autre part, à la ligne de propagation de signaux d'échantillonnage, et
- des moyens pour retarder temporellement la propagation d'un signal d'échantillonnage entre deux moyens d'échantillonnage consécutifs,

caractérisé en ce qu'il comprend des moyens d'amplification distribués en série le long de la ligne de propagation.

Un dispositif d'échantillonnage spatial selon l'invention met en oeuvre autant d'échantillonneurs élémentaires qu'il y a d'échantillons à prélever. Chaque échantillonneur élémentaire ne fonctionne qu'une fois par acquisition. Le signal est propagé sur un support de propagation adapté aux fréquences à analyser, le long duquel se trouvent les échantillonneurs, disposés séquentiellement, de façon à ce que le signal défile devant chacun d'eux avec un décalage de temps lié au pas spatial d'implantation des échantillonneurs et aux moyens de retard temporel du signal d'échantillonnage.

Le signal d'acquisition ou d'échantillonnage est transmis d'échantillonneur en échantillonneur. La combinaison du temps de retard entre deux échantillon et du temps de propagation du signal sur la ligne détermine le pas d'échantillonnage du dispositif. On réalise ainsi un échantillonnage spatial non simultané. Ceci permet de ne pas nécessiter une ligne de propagation très longue altérant le signal de façon non uniforme.

La longueur de cette ligne est supérieure ou égale à la somme des encombrements spatiaux des interrupteurs. Un interrupteur, avec sa connectique, a par exemple un encombrement spatial de 50 μm.

L'invention permet donc d'utiliser une ligne moins grande que celles de l'art antérieur. La ligne peut être plus petite que l'encombrement spatial de l'impulsion à mesurer.

Des moyens peuvent être prévus, sur la ligne de propagation d'ordres d'échantillonnage, pour faire varier le retard entre deux échantillonneurs successifs.

Selon ce mode de réalisation, il est donc possible de faire varier le pas temporel d'échantillonnage, en faisant varier le retard entre deux échantillonneurs successifs. Ce retard peut être choisi par l'utilisateur selon la fréquence d'échantillonnage et la fenêtre d'analyse dont il a besoin.

Selon un autre aspect de l'invention, un échantillonneur électrique comporte une structure de propagation d'impulsions électriques, réalisée sur un premier substrat. Des impulsions de tension sont prélevées sur cette structure de propagation, à l'aide de moyens de prélèvement et de dérivation, réalisés sur un deuxième substrat. En outre, ces moyens sont reliés à des moyens de stockage, ou de stockage et de lecture, des charges correspondant aux impulsions prélevées.

Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :

- Les figures 1 et 2 représentent des échantillonneurs connus,
- les figures 3A à 3D illustrent le fonctionnement d'un dispositif selon l'invention,
- La figure 4 représente un mode de réalisation d'un échantillonneur selon l'invention.
- La figure 5 représente un mode de réalisation d'un dispositif selon l'invention avec deux substrats.
- La figure 6 représente un autre mode de réalisation d'un dispositif selon l'invention avec deux substrats.

Description détaillée de modes de réalisation de l'invention

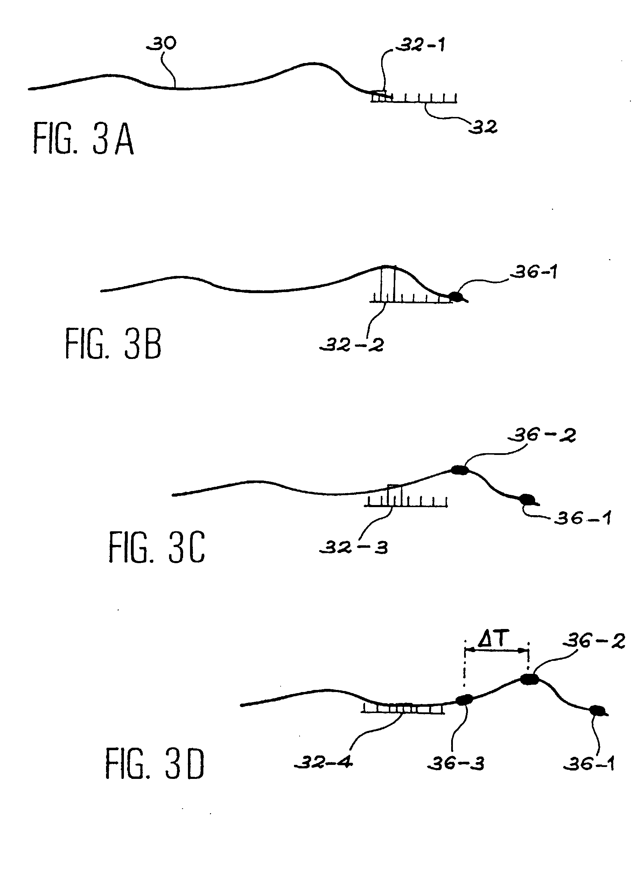

Le principe de fonctionnement d'un échantillonneur selon l'invention va être décrit en liaison avec les figures 3A à 3D.

Un signal 30 à échantillonner va être introduit sur une ligne de propagation 32, laquelle comporte N moyens d'échantillonnage 32-1, 32-2, .... Sur la figure 3A, le début de l'impulsion 30 se situe en face d'un échantillonneur 32-1. La partie du signal identifiée par la référence 36-1 sur la figure 3B est donc échantillonnée. Puis, le signal se propage le long de la ligne de propagation et, à un certain instant, un échantillonneur 32-2 échantillonne une autre partie du signal (partie désignée par la référence 36-2 sur la figure 3C). Le signal continue de se propager et un échantillonneur 32-3 échantillonne une autre partie 36-3 du signal (voir figures 3C et 3D). Ultérieurement, l'échantillonneur 32-4 permet d'échantillonner encore une autre partie du signal (figure 3D).

Afin de commander les échantillonneurs, un signal de commande d'échantillonnage se propage le long d'une ligne de propagation reliée aux différents échantillonneurs. Cette ligne de propagation est alimentée par des moyens pour transmettre des impulsions ou des signaux d'échantillonnage. L'écart temporel $\Delta T$ entre deux points échantillonnés sur le signal (par exemple : 36-1 et 36-2 ou 36-2 et 36-3) dépend donc d'une part de la vitesse de propagation du signal dans la ligne de propagation et, d'autre part, de la vitesse de propagation du signal d'échantillonnage sur la ligne d'échantillonnage. Des moyens, ou dispositifs, de retard peuvent être disposés entre deux moyens d'échantillonnage successifs. Dans ce cas, le retard est réalisé par la combinaison du retard introduit par ce dispositif de retard et du temps de propagation de l'ordre d'échantillonnage d'un échantillonneur à l'échantillonneur voisin.

Un échantillonneur selon l'invention, de type "picoseconde", permet l'échantillonnage d'une impulsion de tension dont le spectre en fréquence s'étend jusqu'à 20 GHz. La fréquence de prélèvement des échantillons est variable selon les phases de l'impulsion que l'on mesure, par exemple de 4 GHz à 20 GHz.

Les échantillons de tension sont donc prélevés par une dérivation de la charge véhiculée par l'impulsion à mesurer.

Le signal de tension est reconstitué à partir d'un certain nombre N d'échantillons. On peut prendre, par exemple N=100 échantillons, codés sur 8 bits, et correspondant à une fenêtre temporelle d'analyse de 25 ns, à 4 GHz ou 5 ns à 20 GHz.

Le signal à mesurer est par exemple injecté par un connecteur coaxial hyperfréquence, ainsi qu'un signal de déclenchement synchrone de l'impulsion à mesurer. Les variations de l'amplitude du signal en fonction du temps peuvent être disponibles en sortie, sur un ordinateur de type PC, pour visualisation ou traitement informatique.

Un dispositif d'échantillonnage spatial selon l'invention met en oeuvre autant d'échantillonneurs élémentaires qu'il y a d'échantillons à prélever. Chaque échantillonneur élémentaire ne fonctionne qu'une fois par acquisition. Le signal est propagé sur un support de propagation adapté aux fréquences à analyser, le long duquel se trouvent les échantillonneurs, disposés séquentiellement, de façon à ce que le signal défile devant chacun d'eux avec un décalage de temps lié au pas spatial d'implantation des échantillonneurs.

L'ordre d'acquisition est transmis d'échantillonneur en échantillonneur, de préférence avec un retard contrôlé. La combinaison de ce retard et du temps de propagation du signal sur la ligne détermine alors le pas d'échantillonnage du dispositif. On réalise ainsi un échantillonnage spatial non simultané.

Selon un exemple de réalisation, la ligne de propagation est une ligne microruban sur saphir, avec 100 points d'échantillonnage espacés de 500 µm. Ces points se trouvent espacés temporellement de 5 ps sur la ligne (le signal passe d'un point à un autre en 5 ps). Pour réaliser un échantillonnage à 20 GHz (50 ps), on introduit un retard de 55 ps entre deux échantillonnages successifs, en commençant à échantillonner par le point situé du côté de l'injection du signal.

On a alors une fenêtre d'analyse de 100x50 ps, soit 5 ns.

L'utilisateur peut modifier le retard à la valeur de 105 ps, il aura alors un pas d'échantillonnage de 100 ps, une fréquence d'échantillonnage de 10 GHz, et une fenêtre d'analyse de 10ns.

Avec un retard de 255 ps, la fréquence d'échantillonnage est de 4 GHz, et la fenêtre d'analyse de 25 ns.

Si le signal à mesurer est introduit à l'autre extrémité de la ligne, le retard entre deux échantillonneurs successifs est de 45 ps pour réaliser une fréquence d'échantillonnage de 20 GHz, de 95 ps pour 10 GHz, et de 245 ps pour GHz.

D'une manière générale, on peut réaliser un retard d'échantillonnage, entre deux interrupteurs ou échantillonneurs, successifs, supérieur à 10 ps.

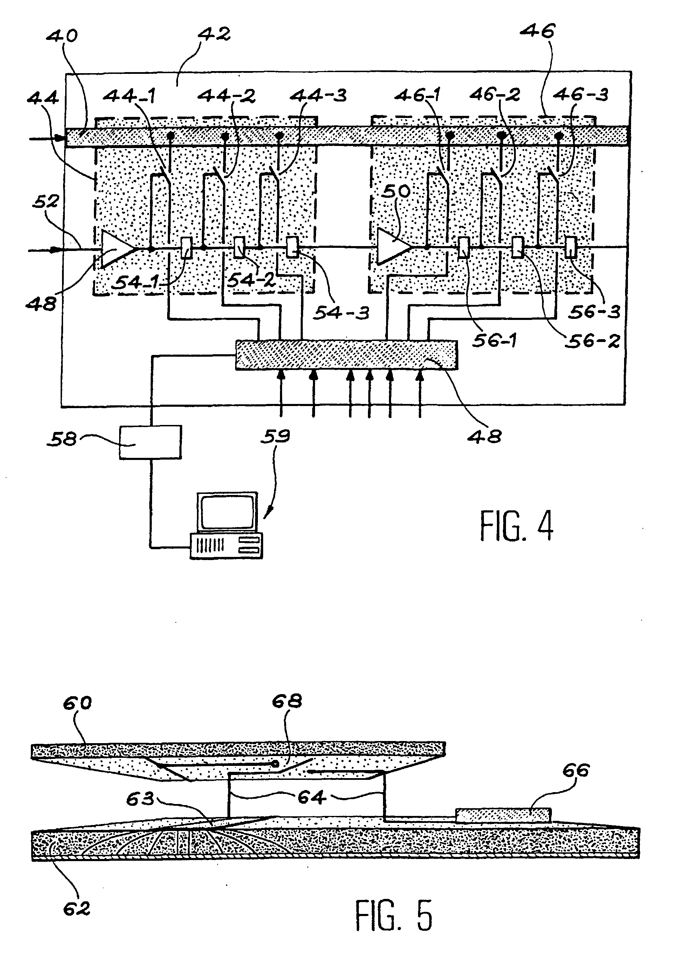

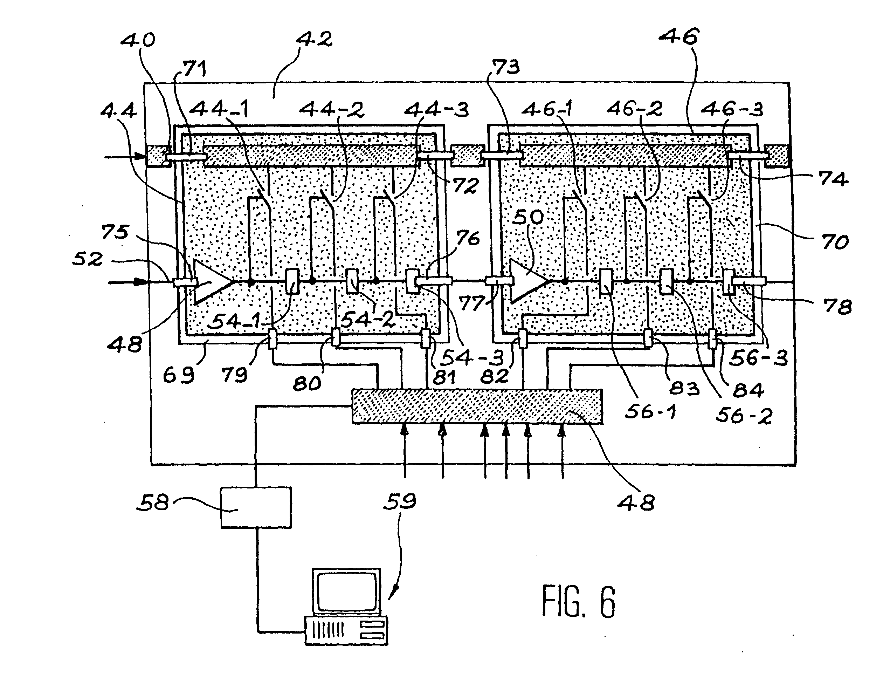

La figure 4 est un exemple de réalisation d'un échantillonneur électrique selon l'invention. L'échantillonneur est réalisé sur une céramique 42 en $Al_2O_3$. Il comporte une ligne microruban 40 et un dispositif d'acquisition 48 (par exemple : un circuit Réticon, ainsi que deux modules 44, 46 réalisés en AsGa. Sur la ligne de propagation de l'impulsion d'échantillonnage 52, et à l'entrée de chacun des modules 44, 46 se trouve un amplificateur 48, 50. Chaque module comporte trois dispositifs d'échantillonnage, ou commutateurs, 44-1, 44-2, 44-3 et 46-1, 46-2, 46-3. Entre deux interrupteurs voisins, et sur la ligne de propagation 52, se trouvent des moyens de retard du signal d'échantillonnage 54-1, 54-2, 54-3 et 56-1, 56-2, 56-3 (ou générateurs de retard). Le signal de synchronisation permet de fermer successivement chacun des interrupteurs, et de prélever un signal correspondant à la partie de l'impulsion qui se situe en face de l'interrupteur au moment où celui-ci est fermé. Un signal correspond à la partie de tension ou de courant se situant sur la ligne de propagation 40, en face de chaque interrupteur au moment où celui-ci est fermé, est transmis au système d'acquisition 48. Ce système d'acquisition peut en outre importer des moyens de traitement et/ou de mémorisation de ces signaux, par exemple des moyens de digitalisation 58. Le dispositif d'acquisition peut être relié à un micro-ordinateur 59, pour visualisation ou traitement informatique.

Selon ce premier mode de réalisation de l'invention, les modules 44 et 46 sont rapportés, de façon connue en soi, sur la céramique 42. La figure 4 est une vue en transparence des modules 44 et 46 à travers la céramique 42.

Les fréquences du signal et les fréquences d'échantillonnage ne sont pas les mêmes (on peut avoir un signal de bande passante égal à 10 GHz, échantillonné à 20 GHz). Pour ces raisons, il est préférable d'utiliser deux substrats différents pour réaliser, d'une part, les moyens de propagation (ligne de propagation) du signal et, d'autre part, les moyens d'échantillonnage de celui-ci. La propagation et l'échantillonnage sont alors chacun réalisés sur le substrat qui lui est le plus adapté. On couple ensuite les deux substrats par des microconnexions, par exemple entre deux plans.

Ce mode de réalisation est illustré sur la figure 5, où la référence 62 désigne un support de propagation d'une ligne microruban 63 sur saphir. En face de ce support, un deuxième substrat 60 semi-conducteur porte les moyens d'échantillonnage 68 (ici, un seul interrupteur est représenté). Des microconnexions 64 permettent d'assurer la liaison entre les deux substrats. Les moyens de stockage et/ou de lecture des informations 66 peuvent être réalisés sur le substrat 62. Un signal est donc retransmis vers un circuit d'acquisition connecté sur un substrat, par l'intermédiaire des microconnexions 64, après échantillonnage. Un tel dispositif permet d'analyser un signal de bande passante jusqu'à 8 GHz, les échantillonneurs pouvant, de leur côté, réaliser des intégrations de charge limitées à des périodes très courtes (de l'ordre de 50 ps), puisqu'elles peuvent être alors réalisées sur un matériau semi-conducteur adapté aux composantes hyperfréquences (par exemple à 20 GHz).

Il est possible de faire une comparaison des longueurs de ligne, dans le cas d'un échantillonnage spatial simultané et dans le cas d'un échantillonnage spatial non simultané.

Si $\Delta t$ est le pas temporel d'échantillonnage voulu et N le nombre de points d'échantillonnage, alors : $F=N\times\Delta t$, où F est la largeur de la fenêtre d'analyse.

Soit V la vitesse de propagation de l'impulsion à mesurer, $l_e$ l'encombrement spatial d'un échantillonneur le long de la ligne et L la longueur de la ligne de propagation de l'impulsion. Alors on a :

- dans le cas d'un échantillonnage simultané :

$$L=N(V\times\Delta t+l_e),$$

- et dans le cas d'un échantillonnage non simultané :

$$L=N\times l_e.$$

Numériquement, si on considère une largeur de fenêtre F=25 nanosecondes, un nombre N=100, V=100 $\mu$m/ps, $l_t$=500 $\mu$m, $\Delta t$=250 picosecondes, alors :

- dans le cas d'un échantillonnage simultané : L=255 cm,
- dans le cas d'un échantillonnage non simultané : L=5 cm.

Avec F=5 nanosecondes et $\Delta t$=50 picosecondes, on a :

- pour un échantillonnage simultané : L=55 cm,
- pour un échantillonnage non simultané : L=5 cm.

La figure 6 représente un troisième mode de réalisation d'un dispositif selon l'invention avec deux substrats. Selon ce mode de réalisation, la ligne de propagation des impulsions électriques est alternativement supportée par le substrat de propagation 42 et par le substrat des modules 44, 46 qui supportent les échantillonneurs. Il en est de même de la ligne de propagation de l'impulsion d'échantillonnage.

Les modules 44 et 46 réalisés sur AsGa sont alors soit placés dans des évidements 69, 70 de la céramique 42 comme représenté en figure 6, soit rapportés sur la céramique 42.

Des connexions 71, 72, 73, 74 permettent alors de relier d'un substrat à l'autre les différentes portions de la ligne de propagation.

Selon ce troisième mode de réalisation de l'invention, la ligne de propagation de l'impulsion d'échantillonnage est également répartie sur le substrat de propagation 42 et sur le substrat des modules 44 et 46. Des connexions 75, 76, 77, 78 permettent alors de relier d'un substrat à l'autre les différentes portions de la ligne de propagation de l'impulsion d'échantillonnage.

Des connexions électriques 79, 80, 81 permettent de relier les interrupteurs respectifs 44-1, 44-2, 44-3 au système d'acquisition 48. De même, des connexions électriques 82, 83, 84 permettent de relier les interrupteurs respectifs 46-1, 46-2, 46-3 au système d'acquisition 48.

Selon ce troisième mode de réalisation de l'invention, la géométrie locale de la ligne de propagation des impulsions électriques peut avantageusement être dessinée en prenant en compte, de façon très précise, les impédances d'entrée des échantillonneurs.

## Revendications

1.  Echantillonneur électrique comprenant :

    -   une structure (40) de propagation d'impulsions électriques,
    -   une ligne de propagation (52) de signaux d'échantillonnage,
    -   N moyens d'échantillonnage distincts (44-1, 44-2, 44-3 ; 46-1, 46-2, 46-3) reliés, d'une part, à des points d'échantillonnage le long de la structure de propagation et, d'autre part, à la ligne de propagation (52) de signaux d'échantillonnage, et
    -   des moyens (54-1, 54-2, 54-3 ; 56-1, 56-2, 56-3) pour retarder temporellement la propagation d'un signal d'échantillonnage entre deux moyens d'échantillonnage consécutifs,

    **caractérisé en ce qu'**il comprend des moyens d'amplification (48, 50) distribués en série le long de la ligne de propagation (52).

2.  Echantillonneur selon la revendication 1, comportant en outre des moyens pour faire varier le retard entre deux moyens d'échantillonnage successifs.

3.  Echantillonneur selon la revendication 1 ou 2, la structure de propagation étant une ligne microruban (40) ou coplanaire.

4.  Echantillonneur selon l'une des revendications 1 à 3 :

    -   la structure de propagation d'impulsions électriques étant réalisée sur un premier substrat (62) ; et
    -   la ligne de propagation de signaux d'échantillonnage étant réalisée sur un deuxième substrat (60).

5.  Echantillonneur selon la revendication 4, les deux substrats étant reliés par des microconnexions (64).

6.  Echantillonneur selon l'une quelconque des revendications 1 à 3, la structure de propagation d'impulsions électriques et la ligne de propagation de signaux d'échantillonnage (52) étant réalisés alternativement sur un premier substrat (42) et sur un deuxième substrat (44, 46), des premières connexions (71, 72, 73, 74) permettant de relier différentes portions de la structure de propagation entre le premier substrat et le deuxième substrat et des secondes connexions (75, 76, 77, 78) permettant de relier différentes portions de la ligne de propagation de signaux d'échantillonnage entre le premier substrat (42) et le deuxième substrat (44, 46).

7.  Echantillonneur selon l'une des revendications 4 ou 5, les moyens d'échantillonnage (68) étant également réalisés sur le deuxième substrat (44, 46).

8.  Echantillonneur selon l'une des revendications précédentes, le retard temporel entre deux moyens d'échantillonnage consécutifs étant supérieur à 10 picosecondes.

## Patentansprüche

1.  Elektrischer Sampler, umfassend:

    -   eine Ausbreitungsstruktur (40) elektrischer Impulse,
    -   eine Abtastsignal-Ausbreitungsleitung (52),
    -   N verschiedene Abtasteinrichtungen (44-1, 44-2, 44-3; 46-1, 46-2, 46-3), einerseits mit Abtastpunkten längs der Ausbreitungsstruktur und andererseits mit der Abtastsignal-Ausbreitungsleitung (52) verbunden, und
    -   Einrichtungen (54-1, 54-2, 54-3; 56-1, 56-2, 56-3) zur zeitlichen Verzögerung der Ausbreitung eines Abtastsignals zwischen zwei aufeinanderfolgenden Abtasteinrichtungen,

**dadurch gekennzeichnet,**

**dass** sie Verstärkungseinrichtungen (48, 50) umfasst, in Serie längs der Ausbreitungsleitung (52) verteilt.

2. Sampler nach Anspruch 1, der außerdem Einrichtungen zum Variieren der Verzögerung zwischen zwei aufeinanderfolgenden Abtasteinrichtungen umfasst.

3. Sampler nach Anspruch 1 oder 2, wobei die Ausbreitungsstruktur eine Mikrostreifenleitung (40) oder koplanare Leitung ist.

4. Sampler nach einem der Ansprüche 1 bis 3:

    - wobei die Ausbreitungsstruktur elektrischer Impulse auf einem ersten Substrat (62) realisiert ist, und
    - die Abtastsignal-Ausbreitungsleitung auf einem zweiten Substrat (60) realisiert ist.

5. Sampler nach Anspruch 4, wobei die beiden Substrate durch Mikroverbindungen (64) verbunden sind.

6. Sampler nach einem der Ansprüche 1 bis 3, wobei die Ausbreitungsstruktur elektrischer Impulse und die Abtastsignal-Ausbreitungsleitung (52) alternativ auf einem ersten Substrat (42) und auf einem zweiten Substrat (44, 46) realisiert sind, erste Verbindungen (71, 72, 73, 74) ermöglichen, verschiedene Teile der Ausbreitungsstruktur zwischen dem ersten Substrat und dem zweiten Substrat zu verbinden, und zweite Verbindungen (75, 76, 77, 78) ermöglichen, verschiedene Teile der Abtastsignal-Ausbreitungsleitung zwischen dem ersten Substrat (42) und dem zweiten Substrat (44, 46) zu verbinden.

7. Sampler nach einem der Ansprüche 4 oder 5, wobei die Abtasteinrichtungen (68) ebenfalls auf dem zweiten Substrat (44, 46) realisiert sind.

8. Sampler nach einem der vorangehenden Ansprüche, wobei die zeitliche Verzögerung zwischen zwei aufeinanderfolgenden Abtasteinrichtungen mehr als 10 Picosekunden beträgt.

**Claims**

1. Electrical sampler comprising:

    - a propagation structure (40) for electrical pulses,
    - N separate sampling means (44-1, 44-2, 44-3; 46-1, 46-2, 46-3) connected to sampling points along the propagation structure, and to the sampling signal propagation line (52),

    - means (54-1, 54-2, 54-3; 56-1, 56-2, 56-3) to time delay the propagation of a sampling signal between two consecutive sampling means,

**characterized in that** it comprises amplification means distributed in series along the propagation line (52).

2. Sampler according to claim 1, additionally comprising means to vary the delay between two successive sampling means.

3. Sampler according to claim 1 or 2, the propagation structure being a micro-ribbon (40) line or coplanar line.

4. Sampler according to one of claims 1 to 3:

    - the structure for the propagation of electrical pulses being created on a first substrate (62) and
    - the sampling signal propagation line being created on a second substrate (60).

5. Sampler according to any one of claims 1 to 3, the structure for the propagation of electrical pulses and the sampling signal propagation line (52) being alternately created on a first substrate (42) and on a second substrate (44, 46), first connections (71, 72, 73, 74) permitting connection of the different portions of the propagation structure between the first substrate and the second substrate and second connections (75, 76, 77, 78) permitting connection of the different portions of the sampling signal propagation line between the first substrate (42) and the second substrate (44, 46).

6. Sampler according to one of claims 4 or 5, sampling means (68) also being created on the second substrate (44, 46).

7. Sampler according to one of the preceding claims, the time delay between two consecutive sampling means exceeding 10 picoseconds.

8. Sampler according to one of the preceding claims, the time delay between two consecutive sampling means exceeding 10 picoseconds.

FIG. 1

FIG. 2

EP 1 084 416 B1

FIG. 3A

FIG. 3B

FIG. 3C

FIG. 3D

FIG. 4

FIG. 5

FIG. 6

EP 1 084 416 B1